# EUROPEAN PATENT APPLICATION

(11) **EP 4 518 637 A1**
(43) Date of publication of application: **05.03.2025**
(21) Application number: 24191484.5
(22) Date of filing: 29.07.2024
(51) Int. Cl.: H10N 70/20, H10N 70/00

(54) **DOUBLE GATE NEUROMORPHIC MEMORY DEVICE AND MANUFACTURING METHOD THEREOF**

(30) Priority: 01.09.2023 KR 20230116491
(71) Applicant: POSTECH Research and Business Development Foundation, Pohang-si, Gyeongsangbuk-do 37673 (KR)
(72) Inventor: KIM, Seyoung, 37664 Gyeongsangbuk-do (KR); KIM, Seungkun, 37673 Gyeongsangbuk-do (KR); SON, JeongHoon, 37673 Gyeongsangbuk-do (KR)
(74) Representative: Germain Maureau

(57) **Abstract**

The present disclosure relates to a double gate neuromorphic memory device and a manufacturing method thereof. The double gate neuromorphic memory device is an electrochemical device, and includes a bottom gate (630) provided on an upper portion of a semiconductor substrate (600), a channel area (640) surrounding the upper portion and side surfaces of the bottom gate (620), a source electrode (660) and a drain electrode (650) provided in contact with both sides of the channel area (640), and a top gate (690) provided on an upper portion of the channel area (640) between the source electrode (650) and the drain electrode (660).

## Description

### TECHNICAL FIELD

The present disclosure relates to a technology for implementing a non-volatile neuromorphic memory device and a synaptic device array, and more particularly, to a newly proposed double gate neuromorphic memory device for improving update characteristics when making up a cross-point array of a synaptic device, and a manufacturing method thereof.

### BACKGROUND

Recently, research on neuromorphic devices that implement neural networks in hardware is progressing in various directions. Neuromorphic devices imitate a structure of neurons and synapses that constitute a brain nervous system of a living body, and generally have a structure of a pre-synaptic neuron located before a synapse, a synapse, and a post-synaptic neuron located after the synapse. The synapse is a connection point between neurons and has a function of updating synaptic weights according to spike signals generated from both neurons and memorizing the updated synaptic weights.

Training and inference processes are performed using a neuromorphic device-based synaptic array developed by simulating the brain's parallel processing of a vector matrix operation based on an artificial intelligence technology, and improve computational performance hundreds of times over existing digital hardware. The memory devices that constitute the synaptic array require not only the typical requirements for the memory devices, but also more stringent requirements. Accordingly, among the memory devices that constitute the synaptic array, ECRAM is composed of three terminals and has the advantage of being easier to control characteristics compared to two-terminal devices because reading and writing processes are separated through this structure. Therefore, research is being conducted on a neuromorphic system capable of improving accuracy through synaptic arrays with three-terminal ECRAM.

### (Prior Art Document)

### (Patent Document)

Korean Patent Application Publication No. 10-2022-0116735 (published on August 8, 2022)

### SUMMARY

In view of the above, the present disclosure provides a sample detection device capable of obtaining a clear image of a sample by lowering the magnification of the device and reducing background noise.

According to embodiments of the present disclosure, a double gate neuromorphic memory device, which is an electrochemical device, includes a bottom gate provided on an upper portion of a semiconductor substrate, a channel area surrounding the upper portion and side surfaces of the bottom gate, a source electrode and a drain electrode provided in contact with both sides of the channel area, and a top gate provided on an upper portion of a channel area between the source electrode and the drain electrode.

The top gate may be formed in a central portion of the channel area, spaced apart from the source electrode and the drain electrode by a predetermined distance so that the channel area is partially exposed on both sides.

The top gate may be formed to partially overlap the source electrode and the drain electrode so that the channel area is not partially exposed on both sides.

A gate electrode layer on an upper end of the top gate may be composed of a barrier metal film containing HfOx, hafnium oxide (HfO₂), titanium nitride, tantalum nitride, tungsten nitride, hafnium nitride, and zirconium nitride.

The gate electrode layer on the upper end of the top gate may be composed of a metal film containing tungsten, copper, hafnium, zirconium, titanium, tantalum, aluminum, ruthenium, palladium, platinum, cobalt, nickel, conductive metal nitrides, and combinations thereof.

The source electrode and the drain electrode may be formed of any one selected from aluminum, copper, nickel, iron, chromium, titanium, zinc, lead, gold, silver, and combinations thereof.

Stacked structures of the top gate and the bottom gate, respectively, may be formed to be symmetrical to each other.

The top gate may be a stacked structure of an electrolyte layer, an ion reservoir layer, and a gate electrode layer, and the bottom gate may have a stacked structure of the gate electrode layer, the ion reservoir layer, and the electrolyte layer, in contrast to the stacked structure of the top gate.

The gate electrode layer on a lower end of the bottom gate may have a structure in which the gate electrode layer is formed to be wider than a line width of the ion reservoir layer and the electrolyte layer of the bottom gate so that a step is generated at the lower end of the bottom gate.

The neuromorphic memory device may include an ion movement-based double gate structure that causes movement of ions between the gate electrode layer and the channel area by applying an external voltage Vg to the top gate.

The neuromorphic memory device may implement 3-terminal and 4-terminal structures with compatibility with a CMOS process, and perform reading and updating operations by separating the bottom gate and the top gate in the 4-terminal structure.

According to embodiments of the present disclosure, a method of manufacturing a double gate neuromorphic memory device, which is a method of manufacturing an electrochemical device, includes forming a bottom gate on an upper portion of a semiconductor substrate, depositing a channel material on the upper portion of the semiconductor substrate including the bottom gate and etching the channel material to form a channel area surrounding the upper portion and side surfaces of the bottom gate, forming a source electrode in contact with one side of the channel area and a drain electrode in contact with the other side of the channel area, and forming a top gate on an upper portion of the channel area between the source electrode and the drain electrode.

The top gate may be formed by stacking an electrolyte layer, an ion reservoir layer, and a gate electrode layer in order.

The bottom gate may be formed by stacking the gate electrode layer, the ion reservoir layer, and the electrolyte layer in order, in contrast to the stacked structure of the top gate.

The gate electrode layer on a lower end of the bottom gate may have a structure in which the gate electrode layer is formed to be wider than a line width of the ion reservoir layer and the electrolyte layer of the bottom gate so that a step is generated at the lower end of the bottom gate.

The gate electrode layer of the lower end of the bottom gate may be formed to have the same line width as the ion reservoir layer and the electrolyte layer of the bottom gate.

The source electrode and the drain electrode may apply an external voltage signal to the top gate and the bottom gate to induce a specific ion behavior in the channel area and a change in conductivity.

The source electrode and the drain electrode may be formed of any one selected from aluminum, copper, nickel, iron, chromium, titanium, zinc, lead, gold, silver, and combinations thereof.

The channel area may be formed of any one of a low-molecular-weight organic semiconductor, an organic semiconductor, a conductive polymer, an inorganic semiconductor, oxide semiconductor, a two-dimensional semiconductor, and a quantum dot.

The channel area may be formed of any one of metal materials including W, Co, Mo, Ti, and Ta.

The disclosed technology may have the following effects. However, since a specific embodiment is not construed as including all of the following effects or only the following effects, it should not be understood that the scope of the disclosed technology is limited to the specific embodiment.

According to the double gate type neuromorphic memory device and manufacturing method thereof according to an embodiment of the present disclosure, it is possible to perform the intelligent training calculation with lower power than the existing digital system by using the double gate type device as the neuromorphic memory device and using the neuromorphic system.

### BRIEF DESCRIPTION OF THE DRAWINGS

FIGS. 1 and 2 are perspective and cross-sectional views for describing a three-terminal-based ECRAM structure of a general neuromorphic memory device.
FIG. 3 is a perspective view for describing a double gate neuromorphic memory device according to an embodiment of the present disclosure.
FIG. 4 is a perspective view for describing the double gate neuromorphic memory device according to the embodiment of the present disclosure.
FIG. 5 is a diagram for comparing an area of an interface between a channel area and a gate, which may induce a change in channel conductivity of the memory device.
FIGS. 6A to 6F are cross-sectional views illustrating a method of manufacturing a double gate neuromorphic memory device according to an embodiment of the present disclosure.

### DETAILED DESCRIPTION

A description of the present disclosure is merely an embodiment for a structural or functional description and the scope of the present disclosure should not be construed as being limited by an embodiment described in a text. That is, since the embodiment can be variously changed and have various forms, the scope of the present disclosure should be understood to include equivalents capable of realizing the technical spirit. Further, it should be understood that since a specific embodiment should include all objects or effects or include only the effect, the scope of the present disclosure is limited by the object or effect.

Meanwhile, meanings of terms described in the present application should be understood as follows.

The terms "first," "second," and the like are used to differentiate a certain component from other components, but the scope of should not be construed to be limited by the terms. For example, a first component may be referred to as a second component, and similarly, the second component may be referred to as the first component.

It should be understood that, when it is described that a component is "connected to" another component, the component may be directly connected to another component or a third component may be present therebetween. In contrast, it should be understood that, when it is described that an element is "directly connected to" another element, it is understood that no element is present between the element and another element. Meanwhile, other expressions describing the relationship of the components, that is, expressions such as "between" and "directly between" or "adjacent to" and "directly adjacent to" should be similarly interpreted.

It is to be understood that the singular expression encompasses a plurality of expressions unless the context clearly dictates otherwise and it should be understood that term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

In each step, reference numerals (e.g., a, b, c, etc.) are used for convenience of description, the reference numerals are not used to describe the order of the steps and unless otherwise stated, it may occur differently from the order specified. That is, the respective steps may be performed similarly to the specified order, performed substantially simultaneously, and performed in an opposite order.

The present disclosure can be implemented as a computer-readable code on a computer-readable recording medium and the computer-readable recording medium includes all types of recording devices for storing data that can be read by a computer system. Examples of the computer readable recording medium may include a ROM, a RAM, a CD-ROM, a magnetic tape, a floppy disk, an optical data storage device, and the like. Further, the computer readable recording media may be stored and executed as codes which may be distributed in the computer system connected through a network and read by a computer in a distribution method.

If it is not contrarily defined, all terms used herein have the same meanings as those generally understood by those skilled in the art. Terms which are defined in a generally used dictionary should be interpreted to have the same meanings as the meanings in the context of the related art, and are not interpreted as ideal meanings or excessively formal meanings unless clearly defined in the present application.

Hereinafter, exemplary embodiments of the present disclosure will be described in more detail with reference to the accompanying drawings. Hereinafter, the same components will be denoted by the same reference numerals throughout the drawings, and an overlapping description for the same components will be omitted.

A memory device that constitutes a neuromorphic system should have several conductivity states in addition to typical requirements of the memory device, and requires more stringent requirements, such as ensuring that the amount of change changes symmetrically when the conductivity states change. In addition, a cross-point array is made into a synaptic device and a half-bias scheme is used to apply voltages of opposite polarity to each row and column in half to perform parallel/selective updates to each device. The half-bias scheme ideally assumes that the change in conductivity does not occur or is negligible in devices to which only half the voltage is applied, but in reality, updates may occur in unwanted devices. The change in conductivity may occur in unselected devices, and when the change occurs, the deep neural network training calculation will not work properly. Therefore, there is a need to ensure that the change in conductivity of the device has non-linear voltage dependence. Accordingly, it is very important to improve device characteristics.

The present disclosure is presented as one of the methods that may contribute to implementing a synaptic device that constitutes an efficient neuromorphic system. To solve this problem, a double gate is used in the existing 3-terminal ECRAM structure to implement a device structure that may maximize an interface where switching may occur, allowing more improved device characteristics while maintaining integration. In addition, by establishing a process method that may be manufactured considering both sputter and ALD processes that are compatible with a CMOS process, the desired conductivity may be adjusted, and in the case of 3 terminals, switching characteristics may be improved with the same voltage level, thereby providing an effect of performing a fast switching speed.

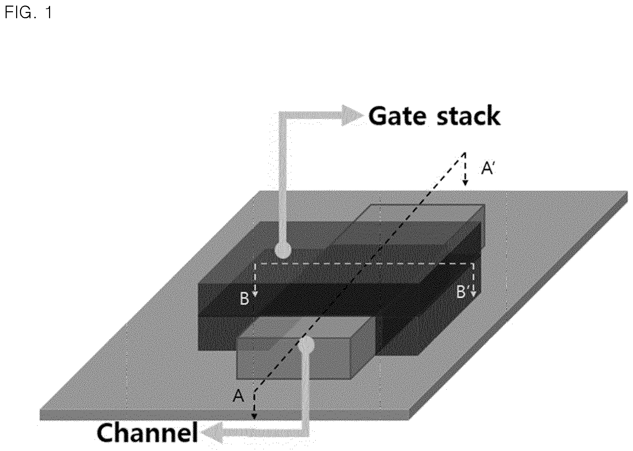

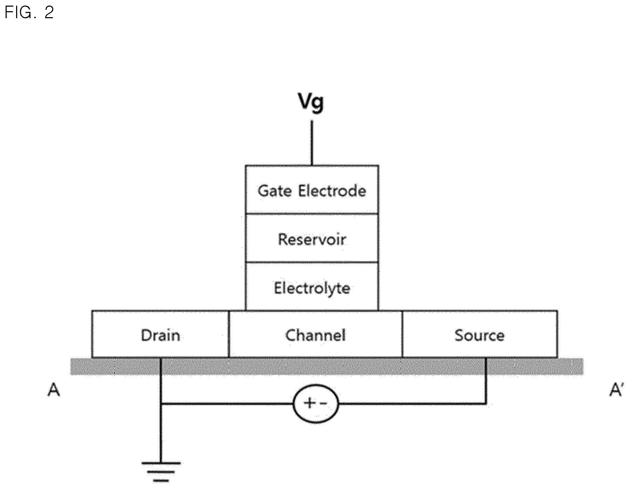

FIGS. 1 and 2 are perspective views and cross-sectional views for describing a 3-terminal-based ECRAM structure of a typical neuromorphic memory device, and FIG. 2 illustrates a cross section taken along the line A-A' of FIG. 1.

Referring to FIGS. 1 and 2, a gate is provided on a semiconductor substrate, and a channel area is provided below the gate. A source electrode and a drain electrode are provided on both sides of the channel area. The gate is formed in the form of a line, and the channel area may be formed in the form of the line intersecting the gate. The gate includes an electrolyte layer and an ion reservoir layer and further includes a gate electrode layer (gate electrode) at an upper end. When an external voltage Vg signal is applied to a gate electrode layer of the upper end of the gate, the conductivity of the channel changes as the behavior of specific ions is induced between a gate stack and the channel area by the applied input signal. The changed channel conductivity may be read through a low read voltage that does not affect the channel between the source and the drain.

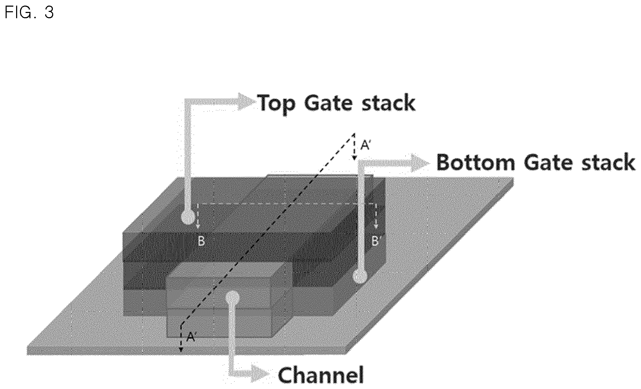

FIG. 3 is a perspective view for describing a double gate neuromorphic memory device according to an embodiment of the present disclosure.

Referring to FIG. 3, a top gate and a bottom gate in the form of the line extending in a first direction are provided on a semiconductor substrate, and the channel area in the form of the line extending in a second direction intersecting the double gate is provided.

The double gate has a structure that includes a bottom gate stack buried in the channel area and a top gate formed in the upper portion of the channel area. Although not illustrated in FIG. 3, it may further include a source electrode and a drain electrode at both ends of the channel area in a major axis direction.

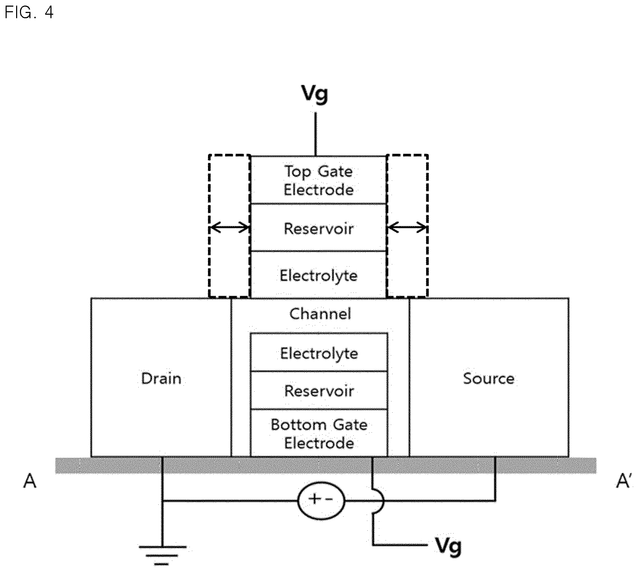

FIG. 4 is a diagram for describing a double gate neuromorphic memory device according to an embodiment of the present disclosure, and is a cross-sectional view taken along the line A-A' of FIG. 3.

Referring to FIG. 4, the double gate neuromorphic memory device of the present disclosure may be composed of the bottom gate, the channel area, the source electrode, the drain electrode, and the top gate.

First, the bottom gate is provided on the upper portion of the semiconductor substrate, and the channel area formed of a channel material is provided on the upper portion and side walls of the bottom gate. The source and drain electrodes are provided on both sides of the channel area, and the top gate is provided on the upper portion of the channel area between the source electrode and the drain electrode. That is, the memory device of the present disclosure has a structure in which two gates are provided on the upper portion and lower portion of the channel area.

To describe the double gate structure in more detail, the bottom gate and top gate may include the electrolyte layer, the ion reservoir layer, and the gate electrode layer, respectively. In this case, the top gate is preferably a structure in which the electrolyte layer, the ion reservoir layer, and the top gate electrode layer are stacked in order, and unlike the top gate, the bottom gate is preferably a structure in which the bottom gate electrode layer, the ion reservoir layer, and the electrolyte layer are stacked in order. FIG. 4 is for explaining a schematic structure of a double gate neuromorphic memory device according to an embodiment of the present disclosure, and the structure of the double gate neuromorphic memory device is not necessarily limited to the same form as FIG. 4 as long as it includes the bottom gate and the top gate.

The 3-terminal memory device illustrated in FIG. 4 applies the voltage (Vg) to the top gate to cause the movement of ions between the gate and the channel area, which changes the conductivity of the channel material between the source electrode and the drain electrode. In this case, the channel area may be formed of WO₃, PCMO, etc., which may improve conductivity when accepting ions, and examples of ions include Li ions, H ions, O ions, etc. Since the memory device with the double gate structure of the present disclosure has two gates formed in the upper portion and lower portion of the channel area, the interface between the channel area and the gate stack is maximized, so the device structure with improved switching characteristics may be implemented.

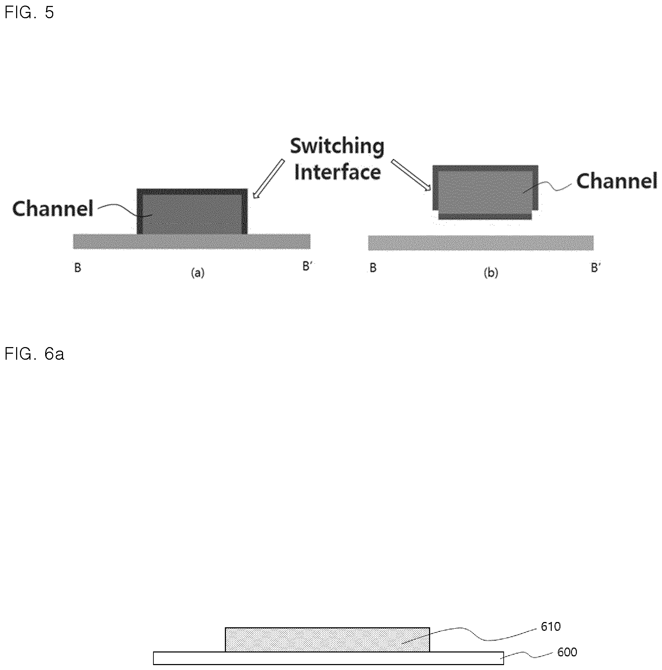

FIG. 5 is a diagram for comparing the area of the interface between the channel area and the gate, which may induce the change in channel conductivity of the memory device. FIGS. 5A and 5B are a cross-sectional view taken along B-B' of FIGS. 1 and 3, respectively.

First, FIG. 5A illustrates the interface that may induce the change in channel conductivity when a 3-terminal-based ECRAM is manufactured on a substrate by a deposition method compatible with the CMOS process, and that is the upper portion of the channel area, and the interface is formed on the upper surface and the side surfaces of the channel area.

Meanwhile, FIG. 5B illustrates the interface that may induce the change in channel conductivity in the ECRAM with the double gate structure of the present disclosure, in which the interfaces are formed on the upper surface, side surfaces, and lower surface of the channel area. In other words, it can be seen that the interface between the channel area and the gate is maximized compared to the existing 3-terminal based ECRAM structure.

FIGS. 6A to 6F are cross-sectional views illustrating a method of manufacturing a double gate neuromorphic memory device according to an embodiment of the present disclosure.

Referring to FIG. 6A, a bottom gate electrode layer 610 is formed on an upper portion of a semiconductor substrate 600. The semiconductor substrate 600 may be a substrate for manufacturing an ECRAM device having a double gate structure using the deposition method compatible with the CMOS process, and may be a silicon substrate, a silicon-on-insulator (SOI) substrate, a germanium substrate, a germanium-on-insulator (GOI) substrate, or a silicon-germanium substrate, but is not necessarily limited thereto.

The bottom gate electrode layer 610 may be composed of a metal film and a barrier metal film. For example, the barrier metal film may be made of HfOx, hafnium oxide (HfO₂), titanium nitride, tantalum nitride, tungsten nitride, hafnium nitride, zirconium nitride, etc., and the metal film may be made of may be made of any one of tungsten, copper, hafnium, zirconium, titanium, tantalum, aluminum, ruthenium, palladium, platinum, cobalt, nickel, and conductive metal nitride or a combination thereof. The deposition processes for forming the bottom gate electrode layer 610 may include physical vapor deposition (PVD), chemical vapor deposition (CVD), sputtering, pulsed laser deposition (PLD), thermal evaporation, electron beam evaporation, atomic layer deposition (ALD), molecular beam epitaxy (MBE), etc.

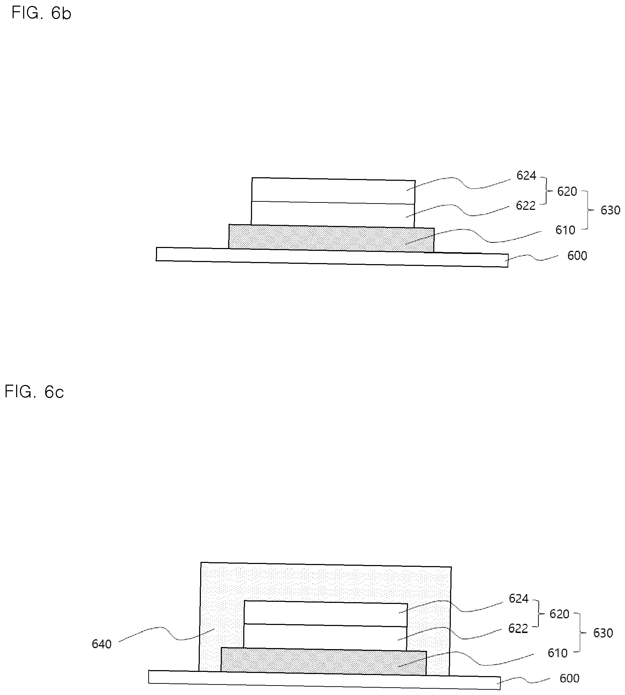

Referring to FIG. 6B, the bottom gate 630 is formed by stacking the bottom gate stack 620 on the upper portion of the bottom gate electrode layer 610. The bottom gate stack 620 is preferably formed by sequentially forming an ion reservoir layer (reservoir) 622 and an electrolyte layer (electrode) 624, and the bottom gate stack 620 is narrower than the bottom gate electrode layer 610 is formed to have a narrower line width than the bottom gate electrode layer 610 to generate a step. However, it is not necessarily limited thereto, and the bottom gate electrode layer 610 and the bottom gate stack 620 may be formed to have the same line width.

Referring to FIG. 6C, a channel material is deposited on the upper portion of the semiconductor substrate 600 including the bottom gate electrode layer 610 and the bottom gate stack 620, and is patterned to form a channel area 640. The channel area 640 may be formed of any one of low molecular weight organic semiconductors, organic semiconductors, conductive polymers, inorganic semiconductors, oxide semiconductors, two-dimensional semiconductors, and materials formed of quantum dots, or may be formed of any one of metal materials such as W, Co, Mo, Ti, and Ta.

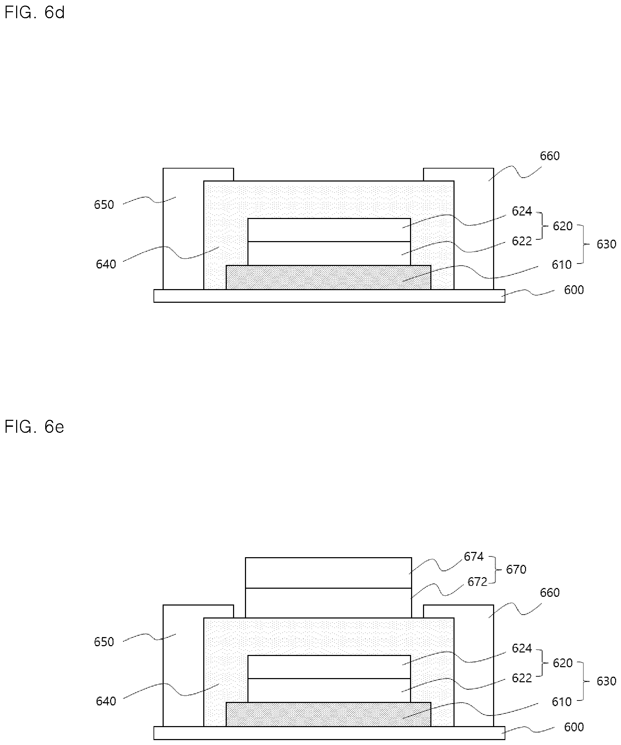

Referring to FIG. 6D, a source electrode 660 and a drain electrode 650 are formed on both sides of the channel area 640. The source electrode and the drain electrode may be formed of any one selected from aluminum, copper, nickel, iron, chromium, titanium, zinc, lead, gold, silver, and combinations thereof. The source electrode and the drain electrode may apply an external voltage signal to the double gate to serve to induce the specific ion behavior in the channel area and read the change in conductivity. Here, in order to read the conductivity of the changed channel area, it is preferable to read a minute conductivity value by applying a low lead voltage that does not affect the channel area between the source electrode and the drain electrode.

Referring to FIG. 6E, a top gate stack 670 is formed in the upper portion of the channel area 640. In this case, the top gate stack 670 may include an electrolyte layer 672 and an ion reservoir layer 674, and may be formed by stacking the electrolyte layer 672 and the ion reservoir layer 674 in the opposite order of the bottom gate stack 620, that is, in the order of the gate stack of the existing 3-terminal ECRAM.

The top gate stack 670 can be formed by sequentially depositing an electrolyte layer and an ion reservoir layer and then patterning the source electrode, drain electrode, and part of both sides of the channel area to be exposed. That is, the top gate stack 670 is formed in the central portion of the channel area spaced apart from the source and drain electrodes at a certain distance. In this case, the channel area 640 may be partially exposed on both sides of the top gate stack 670. Meanwhile, the top gate stack 670 is formed to partially overlap the source electrode or the drain electrode so that the upper portion of the channel area is completely covered by the top gate stack 670, so it does not matter that the channel area is not exposed on both sides of the top gate stack.

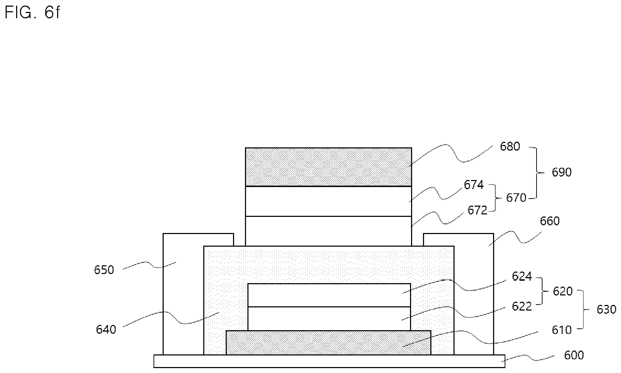

Referring to FIG. 6F, the top gate 690 is completed by forming the top gate electrode layer 680 on the upper portion of the top gate stack 670. The top gate electrode layer 680 is for applying an external voltage signal and may be composed of the metal film and the barrier metal film. For example, the barrier metal film may be made of HfOx, hafnium oxide (HfO₂), titanium nitride, tantalum nitride, tungsten nitride, hafnium nitride, zirconium nitride, etc., and the metal film may be made of may be made of any one of tungsten, copper, hafnium, zirconium, titanium, tantalum, aluminum, ruthenium, palladium, platinum, cobalt, nickel, and conductive metal nitride or a combination thereof. Through this method, the double gate type memory device having the bottom gate 630 and the top gate 690 may be formed on the lower and upper portions of the channel area 640, respectively.

When a voltage or current is applied from the outside to the top gate electrode layer, since active ions move between the gate stack and the channel area due to the applied input signal, and the movement of the active ions changes the amount of active ions in the channel area to change the conductivity of the channel area, the memory device with the double gate structure according to an embodiment of the present disclosure has depression and potentiation characteristics that are the synaptic characteristics.

As described above, the double gate neuromorphic memory device and manufacturing method thereof according to the present disclosure may implement the device structure that maximizes the interface where the switching may occur by applying the double gate to the existing 3-terminal ECRAM structure. In addition, by establishing the process method that may be manufactured by considering both the sputtering and ALD processes that are compatible with the CMOS process, it is possible to improve the device characteristics while maintaining the integration, and implement both the 3 and 4 terminals by expanding from the existing 3 terminals.

Through this, the desired conductivity may be adjusted, and in the case of the 3 terminals, the switching characteristics may be improved with the same voltage level, thereby increasing the switching speed. In addition, in the case of 4 terminals, a voltage may be applied by separating the bottom gate and the top gate, so the switching tendency can be quantitatively analyzed, making it possible to provide the effective device for understanding the ion behavior. To understand the ion behavior, the reading and updating may be performed by separating the bottom gate and the top gate in the 4-terminal structure.

### [Detailed Description of Main Elements]

| | | | |
|---|---|---|---|
| 600: | semiconductor substrate | 610: | bottom gate electrode layer |
| 620: | bottom gate stack | 622, 674: | ion reservoir layer |
| 624, 672: | electrolyte layer | 630: | bottom gate |
| 640: | channel area | 650: | drain electrode |
| 660: | source electrode | 670: | top gate stack |
| 680: | top gate electrode layer | 690: | top gate |

## Claims

1. A double gate neuromorphic memory device which is an electrochemical device, comprising:
a bottom gate provided on an upper portion of a semiconductor substrate;
a channel area surrounding the upper portion and side surfaces of the bottom gate;
a source electrode and a drain electrode provided in contact with both sides of the channel area; and
a top gate provided on an upper portion of a channel area between the source electrode and the drain electrode.

2. The double gate neuromorphic memory device of claim 1, wherein the top gate is formed in a central portion of the channel area, spaced apart from the source electrode and the drain electrode by a predetermined distance so that the channel area is partially exposed on both sides.

3. The double gate neuromorphic memory device of claim 1, wherein the top gate is formed to partially overlap the source electrode and the drain electrode so that the channel area is not partially exposed on both sides.

4. The double gate neuromorphic memory device of claim 1, wherein a gate electrode layer on an upper end of the top gate is composed of a barrier metal film containing HfOx, hafnium oxide (HfO₂), titanium nitride, tantalum nitride, tungsten nitride, hafnium nitride, and zirconium nitride.

5. The double gate neuromorphic memory device of claim 1, wherein a gate electrode layer on the upper end of the top gate is composed of a metal film containing tungsten, copper, hafnium, zirconium, titanium, tantalum, aluminum, ruthenium, palladium, platinum, cobalt, nickel, conductive metal nitrides, and combinations thereof.

6. The double gate neuromorphic memory device of claim 1, wherein the source electrode and the drain electrode are formed of any one selected from aluminum, copper, nickel, iron, chromium, titanium, zinc, lead, gold, silver, and combinations thereof.

7. The double gate neuromorphic memory device of claim 1, wherein stacked structures of the top gate and the bottom gate, respectively, are formed to be symmetrical to each other.

8. The double gate neuromorphic memory device of claim 1, wherein the top gate is a stacked structure of an electrolyte layer, an ion reservoir layer, and a gate electrode layer, and the bottom gate has a stacked structure of the gate electrode layer, the ion reservoir layer, and the electrolyte layer, in contrast to the stacked structure of the top gate.

9. The double gate neuromorphic memory device of claim 8, wherein the gate electrode layer on a lower end of the bottom gate has a structure in which the gate electrode layer is formed to be wider than a line width of the ion reservoir layer and the electrolyte layer of the bottom gate so that a step is generated at the lower end of the bottom gate.

10. The double gate neuromorphic memory device of claim 8, wherein the neuromorphic memory device includes an ion movement-based double gate structure that causes movement of ions between the gate electrode layer and the channel area by applying an external voltage Vg to the top gate.
